**Europäisches Patentamt**

**European Patent Office**

**Office européen des brevets**

(19)

(11) Publication number: **0 368 482**

**A1**

## (12) EUROPEAN PATENT APPLICATION

(21) Application number: **89310473.7**

(22) Date of filing: **12.10.89**

(51) Int. Cl.5: **G02B 3/00, G03F 7/00**

(30) Priority: **14.10.88 GB 8824131**
**25.08.89 GB 8919393**

(43) Date of publication of application:
**16.05.90 Bulletin 90/20**

(84) Designated Contracting States:
**DE FR IT NL**

(71) Applicant: **THE SECRETARY OF STATE FOR TRADE AND INDUSTRY IN HER BRITANNIC MAJESTY'S GOVERNMENT OF THE UNITED KINGDOM AND NORTHERN IRELAND**
**a British Corporate Sole of, 1/19 Victoria Street**
**London SW1H 0ET(GB)**

(72) Inventor: **Hutley, Michael Christopher**
**19 Connaught Road**
**Teddington Middlesex(GB)**

(74) Representative: **Beresford, Keith Denis Lewis et al**
**BERESFORD & Co. 2-5 Warwick Court High Holborn**
**London WC1R 5DJ(GB)**

(54) **Method of making a product with a feature having a multiplicity of fine lines.**

(57) A method of making an array of microlenses comprises forming an interference pattern having a mesh-like array of lines, recording said interference pattern in a layer of photoresist on a substrate, processing said first layer of photoresist to remove material selectively to leave a mesh-like formation of said photoresist material which corresponds to said lines of said interference pattern and which may function as a mesh-like array of astigmatic lenses, transmitting light through said array of astigmatic lenses to form a mesh-like real image made up of lines which are thinner than said lines of said interference pattern, and deriving said microlens array from said real image. The derivation of the microlens array may comprise recording the real image in a further layer of photoresist, removing the portions of the further layer activated by the real image and softening the remaining portions so that they form the microlenses. As an alternative, a mask having light transmissive portions corresponding to the real image may be formed utilising the further layer of photoresist and microlens arrays derived from the mask.

FIG.5

# METHOD OF MAKING A PRODUCT WITH A FEATURE HAVING A MULTIPLICITY OF FINE LINES

This invention relates to a method of making a product which includes a feature having a multiplicity of lines. The invention is particularly applicable to the formation of such a feature in which the multiplicity of lines form a mesh and may be used in the production of microlens arrays.

An article entitled "Holographic Honeycomb Microlens" by James J Cowan which appeared at pages 796 to 801 of the Journal "Optical Engineering" September/October 1985, Volume 24 No. 5 describes the production of a mould having a mesh-like relief pattern on it for the moulding of microlens arrays. In the method described in this article, an intermediate member having the required relief pattern formed thereon in photoresist is produced by exposing the photoresist to a mesh-like interference pattern and then processing the exposed photoresist to produce a relief pattern having a raised zone in the form of a mesh and an array of depressions provided within the mesh. Electrochemical processes may then used to replicate the relief pattern and thereby form the required mould. The mesh-like interference pattern may consist of hexagonal meshes, in which case it may be obtained by causing interference between three beams of collimated light derived from three point sources at the apices of an equilateral triangle, or may, for example, comprise square meshes, in which case these may be produced by creating interference between four collimated beams of light derived from four point sources at the corners of a square. The contents of the aforesaid article are incorporated herein by reference.

The microlens array produced by the above described process comprises a multiplicity of microlenses whose areas are determined by the size of the depressions in the mould. The lenses are separated from each other by non-lens areas the size of which is determined by the thickness of the mesh-like structure constituting the raised portions of the mould. Thus, to maximise the lens areas, it is necessary to minimise the thickness of the mesh-like structure.

An object of the invention, at least in its preferred form, is to provide a method of making a product which includes a feature having a multiplicity of lines which are thinner than those obtainable by the above described process.

In accordance with one aspect of the invention, an array of minute astigmatic optical elements, preferably lenses, is formed, a real image having a line structure corresponding to the required feature is produced by illuminating the array of astigmatic optical elements, and the required feature derived from the real image.

In a further aspect, the invention provides a method of making a product which includes a feature having a multiplicity of lines in which an intermediate element having a structure derived from an interference pattern is produced and the feature of the product is derived from the structure of the intermediate member by a process which results in production of lines thinner than the structure of the intermediate elements.

In accordance with a preferred embodiment of the invention there is provided a method of making a product having a mesh-like feature which comprises forming an intermediate member having a mesh-like relief pattern thereon, utilising said mesh-like relief pattern as an optical element to produce a real image in the form of a mesh and deriving the mesh-like feature of the product from said real image. The real image may be a line image made up of extremely thin lines and, as a result, the mesh-like feature in the product derived from the image may be particularly fine.

The invention may be applied to the production of microlens arrays. For example, a substrate bearing a layer of photoresist which is suitable for forming the lens array itself may be exposed to the above-mentioned real image, developed so that a mesh-like array of depressions is formed corresponding to the real image and thereafter softened temporarily so that the raised area of photoresist within each mesh may become substantially spherical under the effects of surface tension as described, for example, in the article entitled "Technique for Monolithic Fabrication of Microlens Arrays by Popovic et al which appeared at pages 1281 to 1284 of the journal "Applied Optics", 1 April 1988, Volume 27 No. 7, the contents of which are incorporated herein by reference. Instead of exposing the photoresist that is to form the microlens array directly to the aforesaid real image, a mask having a pattern formed from said real image may be created and then the photoresist which is to form the lens array exposed to activating radiation through the mask.

The invention is described further by way of example with reference to the accompanying drawings in which:

Figure 1 is a diagram illustrating an initial step in a process of making a microlens array according to a preferred embodiment of the invention;

Fig. 2 is a micrograph showing an interference pattern produced during the step illustrated in Fig. 1;

Fig. 3 is a cross-section of part of an intermediate member produced subsequent to the step shown in Fig. 1;

Fig. 4 is an interference micrograph of the intermediate member;

Fig. 5 is a diagram illustrating a further step in the process;

Fig. 6 is a micrograph of a real image produced in the step shown in Fig. 5;

Fig. 7 is a cross-section of a member produced following the step illustrated in Fig. 5;

Fig. 8 is a cross-section through the member shown in Fig. 7 following further processing to produce a microlens array;

Fig. 9 is a micrograph of a lens array produced by the process illustrated in Figs. 1 to 8;

Fig. 10 is a diagram showing a step in a modified process;

Fig. 11 is a section through a mask produced following the step of Fig. 10;

Fig. 12 is a plan view of the mask;

Fig. 13 illustrates a further step in the modified process in which the mask of Figs. 11 and 12 is employed; and

Fig. 14 illustrates a further embodiment of the invention.

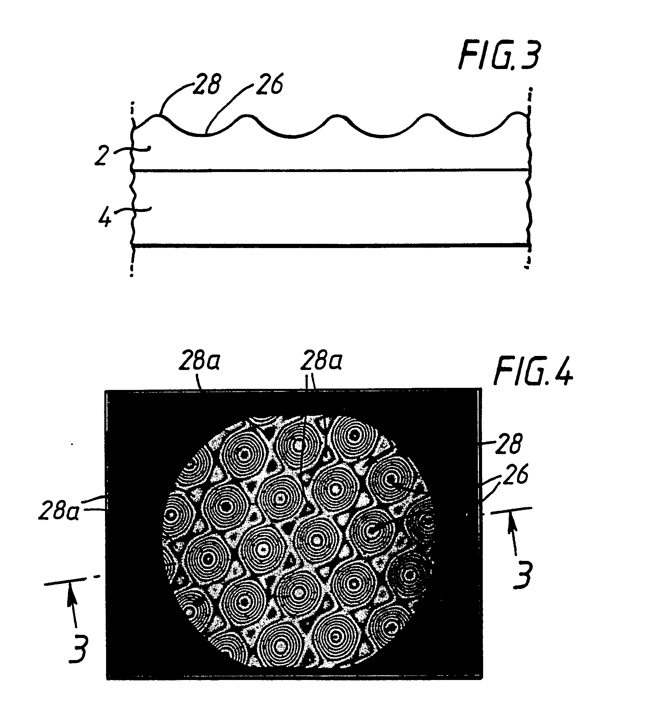

Although the micrographs of Figs. 2, 4, 6 and 9 are included to illustrate different stages in the process according to the preferred embodiment of the invention, they have not been produced with the same magnification as each other.

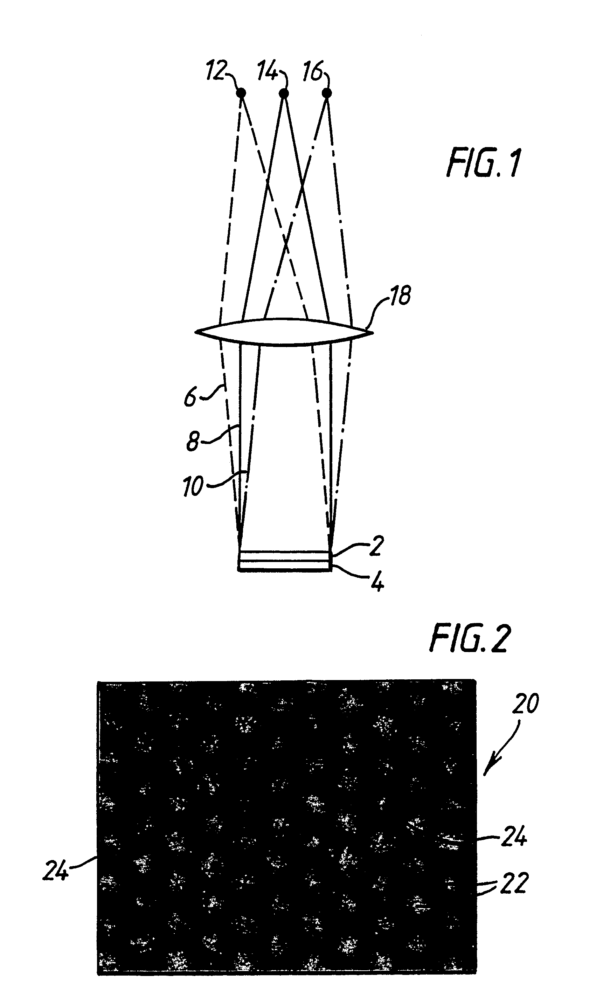

As shown in Fig. 1, a layer of photoresist 2 formed on a transparent substrate 4 is exposed to three collimated light beams 6,8,10 obtained from three coherent point light forces 12,14,16 and a collimating lens 18. Although not shown in Fig. 1, the point sources 12, 14, 16 are positioned at the apices of an equilateral triangle and are all located in the same plane normal to the axis of lens 18. The arrangement may be as described in the aforesaid article by Cowan. The three beams, 6,8,10 interfere to produce an interference pattern 20, as shown in Fig. 2, to which the photoresist 2 is therefore exposed. The interference pattern 20 comprises a substantially regular array of relatively bright zones 22 each surrounded by a relatively dark hexagonal zone 24, the zones 24 being joined to each other to form a mesh-like pattern.

The photoresist 2, after exposure to the pattern 20, is processed to remove material from the zones 22 thereby creating a relief pattern as shown in Fig. 3 in which the lowered portions 26 correspond to the relatively bright zones 22 of the interference pattern and the raised portions 28 are in the form of a mesh-like structure, having approximately hexagonal meshes, corresponding to the portions 24. The interference micrograph of Fig. 4 was produced by causing light reflected from the surface 26,28 of the photoresist 2 to interfere with light reflected from a plane surface. The dark and light zones in Fig. 4 are therefore interference fringes and the dark lines may be considered as contour lines. Thus, Fig. 4 is effectively a contour map of the relief pattern 26,28 of Fig. 3. The photoresist 2 is transparent and, since the substrate 4 is also transparent, at least part of each segment 28a (Fig. 4) of the raised mesh-like structure 28 may act as an approximately cylindrical lens.

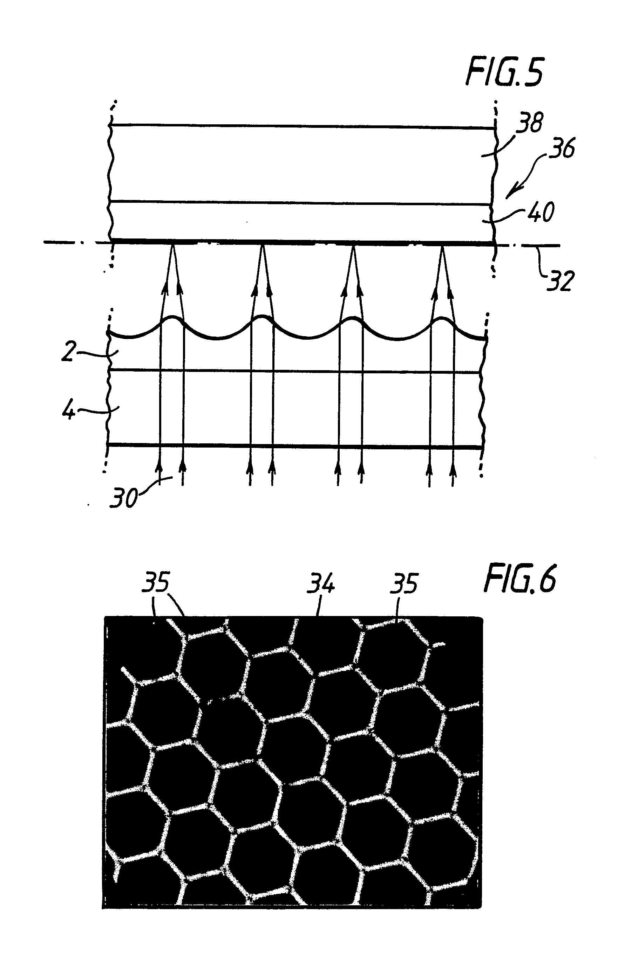

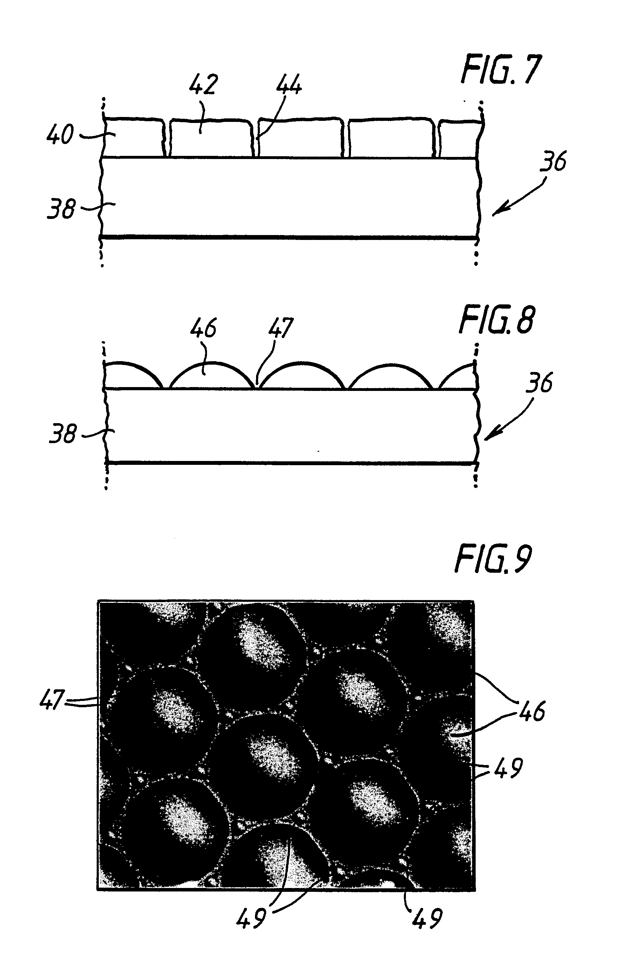

In Fig. 5, a beam of light 30 is transmitted through the photoresist layer 2 from behind the substrate 4 so that the cylindrical lenses 28a produce, in their focal plane 32, a mesh-like real image 34 as shown in Fig. 6. The image 34 may be a line image in which the lines are particularly thin. As shown in Fig. 5, a plate 36 comprising a substrate 38 and a layer of photoresist 40, both of which are transparent, is positioned with the photoresist 40 in the focal plane 32 so that the image 34 is recorded in the photoresist 40. Thereafter, the member 36 is processed to completely remove photoresist at portions exposed to the line image 34 so as to form a relief pattern as shown in Fig. 7 consisting of raised portions 42 separated by thin mesh-like depressions 44. Finally, the photoresist 40 on the member 36 is softened, for example by heating or solvent, so that the portions 42 become substantially spherical due to the effects of surface tension and thus form microlenses 46 as shown in Figs. 8 and 9 and separated from each other by a mesh-like non-lens area 47. Since the lines in the image 34 are very thin, the spacing between the lenses 46 is very small so that the resulting microlens array shown in Figs. 8 and 9 has a very high ratio of lens area to non-lens area i.e. the non-lens area 47 of the array takes up a minimum of space thus resulting in a highly efficient microlens array.

Example

1. The beam form an argon laser operating at 458nm is split into 3 equal beams using appropriate beam splitters.

2. Each beam is focussed through a separate pinhole 25μ in diameter using lenses of 10 mm focal length, the pinholes being at the apices of an equilateral triangle of base 17 mm.

3. A glass blank coated with Shipley S 1400-37 photoresist to a thickness of approximately 5μ is placed at a distance of approximately 2.4m from the pinholes where the three wavefronts overlap. (In this Example, the collimating lens 18 shown in Fig. 1 is omitted).

4. The photoresist is exposed for an appropriate period of time, depending upon intensity of the laser beams and developed using standard techniques to yield a surface covered with a hexagonal array of depressions (26 in Fig. 3) with a pitch of approximately 70$\mu$.

5. The cylindrical positive lenses (28) might typically have focal lengths of 200$\mu$. The array is then placed in proximity to another glass blank similarly coated with photoresist and separated by shims of 200$\mu$ thickness.

6. The second blank is exposed to light from a similar argon laser in which the beam is brought to a point focus typically 300mm from array (2 and 4) and is refocussed by astigmatic lenses of the array (28) onto the surface of the resist (40). Thus, the light from the point focus corresponds to the light 30 illustrated in Fig. 5 and is effectively collimated since the distance (e.g. 300mm) of the point source from the astigmatic lens array is very much greater than the focal length of the astigmatic lenses (e.g. 200$\mu$). Thus the light focussed on to the surface of the resist 40 has the pattern shown in Fig. 6.

7. After exposure the coated blank is developed until the exposed points of the photoresist are removed completely to leave hexagonal "islands" of resist separated by areas of clear substrate.

8. The blank 38 covered with "islands" 42 is then placed in an oven at approximately 150 degrees C for 15 minutes. The islands melt and under the effect of surface tension form hemispherical caps which perform as microlenses.

In practice, the method of the above described example produces convex spherical microlenses 46 as shown in the micrograph of Fig. 9 of excellent shape with relatively thin lines 47 of non-lens region between them, the regions 47 forming a mesh-like pattern. As can be seen in Fig. 9, minute spurious convex spherical lenses 49 are formed at the interstices between the main lenses 46. The spurious lenses 49 arise from the dark zones 35 (Fig. 6) which are present at the junctions between the bright lines which form the mesh-like real image 34 of Fig. 6. Even though the micrographs of Figs. 2, 4, 6 and 9 are taken at different magnifications, it can be seen that the lines making up the real image in Fig. 6 and the zones 47 between the lenses 46 in Fig. 9 are substantially thinner than the dark lines 24 of the interference pattern in Fig. 2 and the raised portions 28 of the structure shown in Figs. 3 and 4.

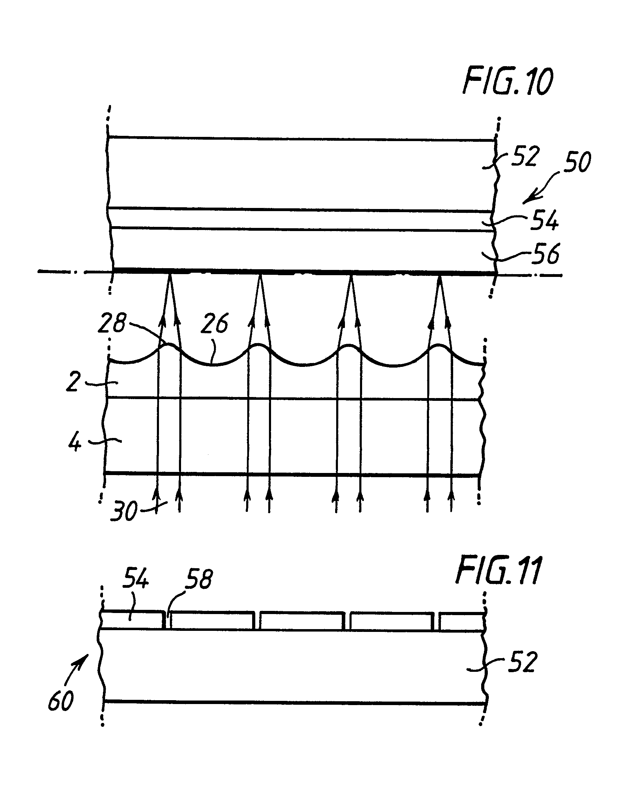

In the alternative embodiment shown in Figs. 10 to 13, the initial steps are as described with reference to Figs. 1 to 4. However, instead of the member 36 shown in Fig. 5, a member 50 is provided comprising a transparent substrate 52, a layer of aluminium or other opaque material 54 and a layer of photoresist 56. In the same manner as described with reference to Fig. 5, the photoresist layer 56 is positioned in the focal plane 32 and exposed to the real mesh-like line image 34 of Fig.

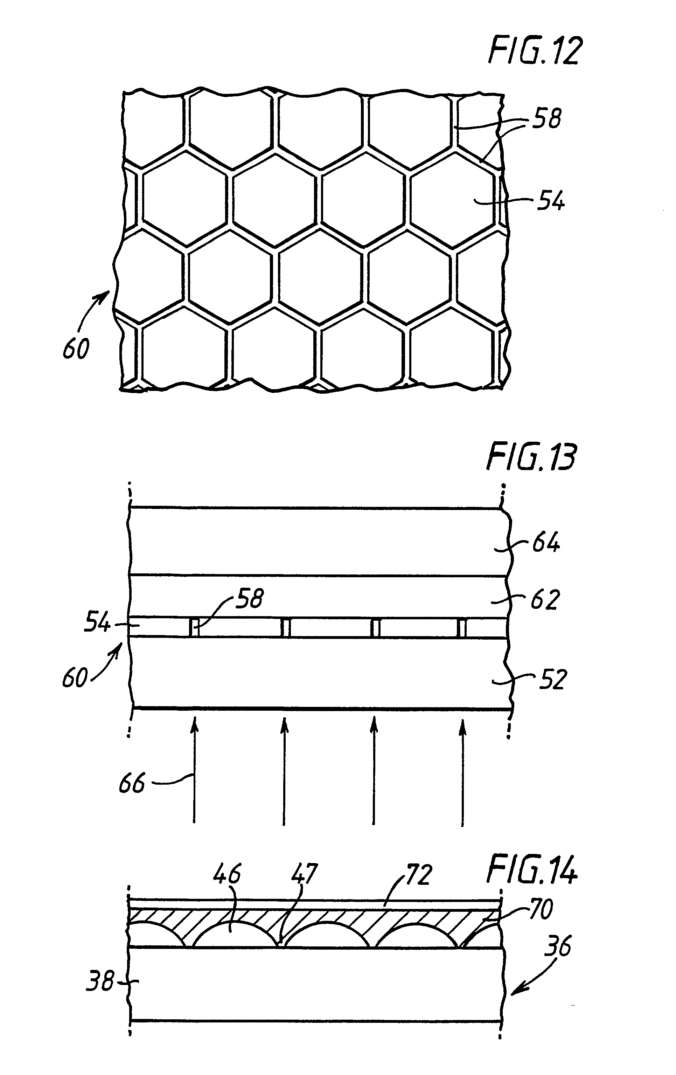

6 by transmitting the collimated light beam 30 through the substrate 4 and photoresist 2. After exposure of the photoresist 56 to the line image 34, the member 50 is processed so as to remove portions of the aluminium layer 54 in regions below the portion of the photoresist exposed to the line image 34 and therefore form a hexagonal mesh pattern of slits 58 in the aluminium layer 54 thus to form a mask on the substrate 52 as shown in Figs. 11 and 12. The width of the slits 58 is very small in view of the thinness of the lines in the image 34. During the formation of the mask 60, the whole of the layer of photoresist 56 is preferably removed.

After the mask 60 has been formed it is then used in the formation of the microlens array by firstly exposing a layer of photoresist 62 on a substrate 64 to light 66 through the mask 60 in a contact printing step as shown in Fig. 13 and thereafter carrying out the steps described with reference to Figs. 7 and 8 to produce a microlens array. Again, in view of the fineness of the lines of the image 34, the resulting microlens array is as described with reference to Fig. 9 i.e. the spacing between the lenses is very small.

The above methods work well where lenses of relatively short focal length and high numerical aperture are to be produced (the islands 42 shown in Fig. 7 being, for example, perhaps 20 micrometers thick and a 100 micrometers in diameter). The production of lenses with longer focal length and lower numerical aperture requires thinner islands of resist and as a result the forces of surface tension are insufficient to draw the material into a spherical shape when it is softened. This problem may be overcome, as shown in Fig. 14, by providing, on top of the array of lenses 46, a layer of optical cement 70 whose refractive index is intermediate the refractive indices of the material from which the lenses 46 are made and air. A plane glass plate 72 is placed upon the cement 70 in order to hold the cement 70 in place while it sets and to provide a substantially planar surface. The plane glass plate 72 remains secured to the lens array by the cement 70 after the cement has set.

If the material from which the lenses 46 are made has a refractive index $n_1$ and the cement 70 has a refractive index $n_2$ the focal length of f of a given said lens 46 is:

$$f = \frac{n_1 r}{(n_1 - n_2)}$$

where r is the radius of curvature and the focal point lies inside medium $n_1$.

Thus, as $n_2$ approaches $n_1$, the denominator

approaches zero and f approaches infinity so that a wide range of focal lengths may be achieved by selection of materials for the lenses and cement with appropriate refractive indices.

The term $n_1 - n_2$ it may be positive or negative, thus providing for the possibility of converging or diverging lenses.

Thus, the arrangement shown in Fig. 14 may have a relatively long focal length despite the lenses themselves each having a relatively small radius of curvature. A further advantage of the arrangement shown in Fig. 14 is that since the refracting surface of the lens is buried, the glass plate 72 may be cemented to other optical elements such as optical fibres or other arrays, without affecting the action of the microlens arrays.

Applications for the arrangement of Fig. 14 include the use of the lens array in conjunction with single mode optical fibres. The numerical aperture of such as fibre might typically be 0.125 whereas, without the cement 70 and glass plate 72, the numerical aperature of the lenses 46 might be of the order of 0.25.

Microlenses made in accordance with the invention may have a number of applications, for example:

1. Integral photography as described by Lippmann C R 146 acad sci Paris pp446-451, 2 March 1908

2. Superlenses as described by Gabor.

3. Increasing the efficiency of light detector arrays by focussing light onto the sensitive areas.

4. Connections for arrays of optical fibres.

5. Retro-reflective screens.

6. Components in interconnects in optical computers and digital optical data systems.

7. Focussing Screens

8. Controlled Diffusers.

Although the invention has been described in relation to the manufacture of microlens arrays, it may be applied to the manufacture of other products in which a thin mesh-like feature is required. The invention is particularly advantageous since it permits the economic and rapid production of thin mesh-like structures in which the structure is thinner than obtainable by the process described by Cowan. Further, the mesh-like feature. might, for example, merely be a two-dimensional pattern instead of forming part of three dimensional surface features as in a microlens array.

Various modifications are possible within the scope of the invention. For example, instead of the contact printing step shown in Fig. 13, the mask pattern 58 could be transferred to the photoresist 62 by projecting an image of the mask pattern on to the photoresist 62 utilising lenses or other means. Further, instead of exposing the layer of photoresist, such as layer 40 or layer 56, which is to form the microlens array to the real image 34 or the pattern of mask 58 it would be possible to derive from the real image 34 or mask pattern 58 a mould which would then be used for moulding a mesh structure. In the mould produced by this method, the mesh-like raised structure surrounding the depressions which are used for moulding the lenses would still be much thinner than available in the prior art since such structure is derived from the thin line image 34.

Although the embodiment illustrated in the drawings has utilised a hexagonal interference pattern (Fig. 2) other patterns are possible. For example, a mesh-like pattern having square shaped meshes might be produced for example by means of four coherent point light sources located at the corners of a square, the light from which would be collimated for forming the interference pattern.

Further, although the preferred embodiment of the invention concerns the production of spherical microlenses and represents a substantial improvement in this particular field, the invention could as an alternative be applied to the production of an array of minute cylindrical lenses. In this case, the initial interference pattern might consist of straight lines as produced by interfering two beams of light, an intermediate member consisting of substantially straight, parallel cylindrical lenses would be produced from the interference pattern by recording the interference pattern in photoresist and then processing the photoresist, and this array of cylindrical lenses may then be illuminated uniformly to produce a real image consisting of thin parallel lines from which the final minute array would be derived by recording the real image in a further layer of photoresist and processing the further layer of photoresist. In this way, a microlens array of parallel cylindrical lenses could be produced with minimum spacing between the lenses. Further, other products which include a feature having a multiplicity of parallel straight lines or lines in other configurations, may be produced in accordance with the invention.

As further alternatives, it would be possible to utilize for the cement 70 shown in Fig. 14 a material whose refractive index is greater than that of the material of the lenses in order to produce diverging lenses. Further, the values of the refractive index of the material chosen for the lenses 46 and the cement 70 could be selected to control aberrations, such as chromatic or spherical aberration of the lenses.

As yet a further alternative, it would be possible to form a microlens array of spherical lenses utilising the real image consisting of thin straight parallel lines mentioned in the intermediately preceding paragraph. Thus, a layer of photoresist which is to form the cylindrical microlenses could be subjected to a first exposure in which the real image is oriented in a first direction and then to a second exposure in which the real image is oriented at 90 degrees to said first direction, subsequent processing of the photoresist resulting in removal of crossed lines of photoresist forming a square pattern. Softening of the photoresist, for example by solvent or heat, would then result in the formation of the lenses due to surface tension as previously described.

## Claims

1. A method of making a product which includes a feature having a multiplicity of lines, comprising producing an intermediate member having a structure which is derived from an interference pattern and which may function as a multiplicity of astigmatic optical elements, illuminating said structure so that said astigmatic optical elements produce a real image having a multiplicity of lines, and deriving said feature of said product from said real image.

2. A method according to claim 1, wherein said multiplicity of lines of said feature form a mesh.

3. A method according to claim 2, wherein said interference pattern is in the form of a mesh.

4. A method according to claim 3, wherein said interference pattern is in the form of a hexagonal mesh.

5. A method according to claim 4, wherein said interference pattern is obtained by causing three beams of light to interfere.

6. A method according to claim 3, wherein said interference pattern is in the form of a square mesh.

7. A method according to claim 6, wherein said interference pattern is obtained by causing four beams of light to interfere.

8. A method according to any preceding claim, wherein said interference pattern is recorded in photoresist material, and said photoresist material is processed and said astigmatic optical elements produced therefrom in an array which corresponds substantially to the interference pattern.

9. A method according to claim 8, wherein said optical elements are lenses.

10. A method according to claim 9, wherein said lenses are constituted by said process photoresist material.

11. A method according to any preceding claim, wherein said real image is produced by illuminating said astigmatic optical elements substantially uniformly with substantially collimated light.

12. A method according to claim 11, wherein said substantially collimated light is obtained from a point source located at a sufficient distance from said astigmatic optical elements relative to the focal length thereof that the light from said point source is effectively collimated.

13. A method according to any preceding claim, wherein the derivation of said feature of said product from said real image includes recording said real image in photoresist material, and then processing the photoresist material in which the real image is recorded and forming said feature therefrom.

14. A method according to claim 13, comprising removing the portions of the photoresist in which said real image is recorded and softening the remaining portions such that said remaining portions form a multiplicity of microlenses in an array defined by said feature.

15. A method according to claim 13, wherein said processing of said photoresist with said real image recorded therein comprises removing the portions of said photoresist in which said real image is recorded and forming a mask having light transmissive portions corresponding to the removed portions of photoresist.

16. A method according to claim 15, which comprises deriving a microlens array from said mask by exposing further photoresist to illumination through said mask, processing said further photoresist to remove portions illuminated through said mask and softening the remaining portions to form said microlens array.

17. A method of making an array of microlenses which comprises forming an interference pattern having a mesh-like array of lines, recording said interference pattern in a layer of photoresist on a substrate, processing said layer of photoresist to remove material selectively to leave a mesh-like formation of said photoresist material which corresponds to said lines of said interference pattern and which may function as a mesh-like array of astigmatic lenses, transmitting light through said array of astigmatic lenses to form a mesh-like real image made up of lines which are thinner than said lines of said interference pattern, and deriving said microlens array from said real image.

18. A method according to any of claims 14 to 17, including providing on said microlenses a layer of material of refractive index intermediate that of the material of the lenses and air.

19. A method according to claim 18, wherein said layer of material provided on said lenses is optical cement.

20. A method according to claim 19, including providing a glass plate on said cement, said glass plate being secured to said microlens array by said cement.

21. A method according to claim 18 or 19, wherein said layer of material has a refractive index such as to compensate at least to some extent for aberration in said microlenses.

22. A method according to any of claims 14 to 17, including providing on said microlenses a layer of material of refractive index greater than that of the material of the lenses.

23. The product of a method according to any preceding claim.

*FIG.1*

*FIG.2*

FIG.3

FIG.4

FIG.5

FIG.6

*FIG.7*

*FIG.8*

*FIG.9*

EP 0 368 482 A1

*FIG.10*

*FIG.11*

*FIG.12*

58

54

60

*FIG.13*

64

62

58

54

60

52

66

*FIG.14*

46   47   72

70

36

38

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A,D | OPTICAL ENGINEERING<br>vol. 24, no. 5, September/October 1985,<br>pages 796-802; J.J. COWAN: "Holographic<br>honeycomb microlens"<br>--- | 1-10,17<br>,23 | G 02 B 3/00<br>G 03 F 7/00 |
| A | JOURNAL OF VACUUM SCIENCE & TECHNOLOGY<br>vol. 16, no. 6, November/December 1979,<br>pages 1949-1952; D.C. FLANDERS et al.:<br>"Spatial period division - A new<br>technique for exposing<br>submicrometer-linewidth periodic and<br>quasiperiodic patterns" * introduction<br>*<br>--- | 1,17 | |
| A | US-A-4 668 080 (M. T. GALE et al.)<br>* figures 2,4; column 5, line 40 -<br>column 6, line 22 *<br>----- | 1,17 | |

TECHNICAL FIELDS
SEARCHED (Int. Cl.5)

G 02 B 3/00
G 02 B 5/00
G 03 F 7/00
G 03 C 5/00

The present search report has been drawn up for all claims

| Place of search | Date of completion of the search | Examiner |
|---|---|---|
| BERLIN | 15-01-1990 | VON MOERS F |

EPO FORM 1503 03.82 (P0401)